# EUROPEAN PATENT APPLICATION

(11) **EP 2 444 769 A1**
(43) Date of publication of application: **25.04.2012**
(21) Application number: 10187869.2
(22) Date of filing: 18.10.2010
(51) Int. Cl.: F28D 15/02, F28F 3/12, F28F 19/00, F28F 21/00, F25B 9/02, H01L 23/427, H05K 7/20

(54) **Micro-cooling device**

(71) Applicant: Kryoz Technologies B.V., 7521 PV Enschede (NL)
(72) Inventor: Lerou, Pieter-Paul Patrick Maurits, 7521 PV, Enschede (NL)
(74) Representative: 't Jong, Bastiaan Jacob

(57) **Abstract**

Micro-cooling device comprising:
- an elongate body having a first end and an opposite second end;
- an evaporation chamber arranged at the first end of the elongate body;
- a feed channel arranged between a feed opening, for feeding a high pressure cooling medium, at the second end of the elongate body and the evaporation chamber;
- a discharge channel arranged between the evaporation chamber and a discharge opening at the second end of the elongate body;
- a restriction arranged in the feed channel and adjacent to the evaporation chamber, wherein

the evaporation chamber comprises a chamber section extending beyond the restriction and being in heat exchanging contact with a first zone of the feed channel upstream of the restriction.

## Description

The invention relates to a micro-cooling device comprising:
- an elongate body having a first end and an opposite second end;
- an evaporation chamber arranged at the first end of the elongate body;
- a feed channel arranged between a feed opening, for feeding a high pressure cooling medium, at the second end of the elongate body and the evaporation chamber;
- a discharge channel arranged between the evaporation chamber and a discharge opening at the second end of the elongate body;
- a restriction arranged in the feed channel and adjacent to the evaporation chamber.

Such a device is known from the thesis "Micromachined Joule-Thomson cryocooler" from the inventor P.P.P.M. Lerou.

The micro-cooling device can be used for cooling electronic devices, such as amplifiers or integrated circuits, to very low temperatures. This results in a better efficiency of the electronic devices, like for example a very high signal to noise ratio.

The cooling effect of the device is based on the Joule-Thomson cycle. A cooling medium is pumped under high pressure in the feed opening. The cooling medium is transported along the feed channel towards the restriction. The restriction will cause a pressure drop in the feed channel, resulting in a temperature drop and phase change of the cooling medium. By evaporation of the medium cooling to the low temperature at the evaporation chamber is accomplished.

The evaporated cooling medium is discharged from the evaporation chamber through the discharge channel and the discharge opening. The discarded cooling medium can then be reused by compressing the medium and feeding it again to the feed channel.

A typical cooling medium used for this known micro-cooling device is nitrogen. The dimensions of the channels in such a known device are typically about 50 micrometer, whereas the restriction has openings of about 300 - 1000 nanometer.

When using a device having such small dimensions, the purity of the cooling medium is of concern. When obtaining a cooling medium, in particular nitrogen, there will always be some contamination. Even the purest nitrogen commercially available still contains 1 part per million of water molecules. Due to the low temperatures achieved in the known cooling device, the water molecules will freeze or more correctly deposite to the solid phase.

The generated ice will accumulate on the walls of the feed channel or the support structures arranged in the feed channel, which are provided to withstand the high pressure of the cooling medium.

The accumulation of the ice could be on the openings in the restriction or ice particles will break off in front of the restriction and get stuck in the openings of the restriction. This will block the restriction preventing the micro-cooling device from functioning correctly.

The blockage of the restriction can be resolved by warming up the device, such that the ice is sublimated again. However, during this period of warming the device, the continuous operation of the device is interrupted which results in interrupted operation of the electronic components, which need to be cooled.

As the blockage of the restriction may already occur after a few minutes, the micro-cooling device according to the state of the art is not suitable for commercial application, which requires a maintenance free cooling device, or a cooling device which can operate for several months or years without any substantial interruptions.

Also the blockage by other irregularities in the cooling medium can cause problems and even make the device unusable.

It is an object of the invention to reduce or even remove the above mentioned disadvantages of the prior art.

This object is achieved with a micro-cooling device according to the preamble, which is characterized in that the evaporation chamber comprises a chamber section extending beyond the restriction and being in heat exchanging contact with a first zone of the feed channel upstream of the restriction.

The chamber section provided by the invention ensures that the first zone of the feed channel upstream of the restriction is also cooled to virtually the same temperature as the evaporation chamber. So, the first zone of the feed channel also has the same temperature as the part downstream of the restriction. As a result the water molecules will deposite earlier in the feed channel, reducing the chance of blocking the restriction by ice deposition.

An embodiment of the micro-cooling device according to the invention comprises an attachment zone in heat exchanging contact with the evaporation chamber, for attaching an electronic component. Preferably a silicon layer is arranged to the attachment zone. The silicon layer has excellent heat dispersing characteristics, such that the heat extraction by the evaporation process in the evaporation chamber is evenly distributed over the surface of the attachment zone.

In a preferred embodiment of the micro-cooling device according to the invention filter means are arranged in the first zone of the feed channel. Preferably the filter means comprise a plurality of pillars projecting in the feed channel.

The filter means provide a filter for filtering the water molecules from the cooling medium. By providing a plurality of pillars in the first zone of the feed channel, sufficient surface is provided for the water molecules to deposite on. As the evaporation chamber cools the first zone of the feed channel, the pillars in this first zone are cooled to the lowest temperature in the device and ensures that the water molecules will deposite on the surface of the pillars, before the molecules reach the restriction.

In another preferred embodiment of the device according to the invention at least one particle trap is arranged in the first zone of the feed channel. This particle trap preferably comprises a plurality of passage openings having dimensions of the same magnitude as the restriction.

The particle trap provides passage openings of similar dimensions as the restriction. The total cross sectional surface of the openings of the passage openings is substantially larger, than the total cross sectional surface of the restriction. So, when particles, like ice parts, arrive at the particle trap some of the passage openings will be closed off, but due to the amount of openings, no substantial reduction in the flow will occur nor any substantial pressure drop will be present over the particle trap.

Another very preferred embodiment of the micro cooling device according to the invention comprises:
- a temperature sensor arranged in heat exchanging contact with the feed channel and upstream from the first zone;
- a heater arranged in heat exchanging contact with the evaporation chamber;
- control means for controlling the heater dependent on the temperature sensor measurements.

In order to maintain the temperature in the evaporation chamber at a constant level independent on the heat dissipation of an electronic device arranged at the attachment zone, a heater and a temperature sensor are arranged. The heater is provided to add additional heat and to control the temperature by dissipating more or less power in the heater. The temperature sensor is arranged in heat exchanging contact with the feed channel. The temperature at a position along the feed channel is related to the heat dissipation at the evaporation chamber. The temperature at the feed channel is however higher than at the evaporation chamber and non-constant, accordingly the temperature profile can be controlled more sensitively. By measuring the temperature the heater can be controlled such that the temperature at the evaporation is kept at a desired level.

Preferably, the position of the temperature sensor is selected such that the sensor measures the temperature at a steep part of the temperature curve along the length of the feed channel. A fluctuation in the temperature of the evaporation chamber, will result in a substantial shift in the measured temperature due to the steep part of the temperature curve. This shift is more easily measured resulting in a good control of the temperature at the evaporation chamber.

In still another embodiment of the micro-cooling device the feed channel and discharge channel are in counter-flow heat exchanging contact. By bringing the feed channel and discharge channel in heat exchanging contact with each other, the supplied cooling medium is already cooled, before it enters the restriction and the medium is cooled further by the pressure reduction.

The device is preferably composed out of micro-machined glass layers. With micro-machined glass layers the small dimensions necessary for the restriction can be achieved. Another advantage of glass is that the heat conductivity is small, such that the first end with the evaporation chamber can have a low temperature and the second end can be in contact with a relative high temperature without a substantial heat leak from the second end to the first end.

Still another embodiment comprises a compressor with a low pressure inlet connected to the discharge opening and a high pressure outlet connected to the feed opening. The compressor is preferably a compressor without moving parts, like a sorption compressor.

These and other advantages of the invention will be elucidated in conjunction with the accompanying drawings.
Figure 1 shows a cross sectional side view of an embodiment of a micro-cooling device according to the invention.
Figure 2 shows a cross sectional top view of the embodiment of figure 1.

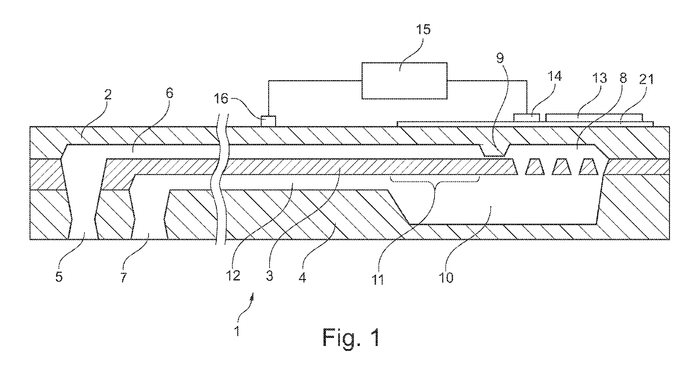

In figure 1 an embodiment of a cooling device 1 of the invention is shown. This device 1 is composed out of micromachined glass layers 2, 3, 4. These glass layers 2, 3, 4 form a feed opening 5 and an discharge opening 7 at a second end of the elongate body of the device 1. At the first end an evaporation chamber 8 is arranged. The feed channel 6 runs from the feed opening 5 towards the evaporation chamber 8. A restriction 9 is arranged in the feed channel 6 near the evaporation chamber 8.

When a cooling medium, like nitrogen, is fed under pressure to the feed opening 5 and transported along the feed channel 6 to the restriction 9 a pressure drop will occur behind the restriction 9. As a result the cooling medium will cool down in the evaporation chamber 8, such that the temperature will drop and the cooling medium will change phase.

The evaporation chamber 8 has a chamber section 10, which extends beyond the restriction 9 and under a first zone 11 of the feed channel 6. Due to the chamber section 10, the temperature can be as low in the first zone 11 as in the evaporation chamber 8.

The evaporated cooling medium is discharged from the chamber section 10 through the discharge channel 12 and the discharge opening 7.

Above the evaporation chamber 8 an attachment zone with an electronic device 13 on top of a high-conductive layer 21 (e.g. silicon) is arranged. The low temperature in the evaporation chamber 8 enables the cooling of the electronic device 13.

Adjacent to the electronic device 13 a heater 14 is arranged. This heater 14 is controlled by a controller 15, which measures the temperature in the feed channel 6 with a temperature sensor 16. The temperature at the sensor 16 is related to the temperature in the evaporation chamber 8, 10 and the first zone 11, as the cooling medium in the discharge channel 12 will exchange heat with the cooling medium in the feed channel 6.

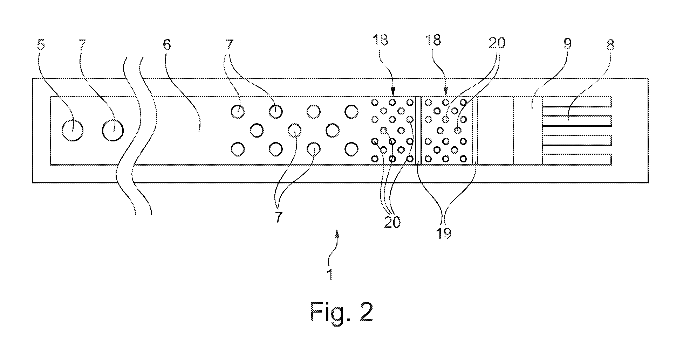

Figure 2 shows a cross sectional top view of the cooling device 1. In the feed channel 6 pillars 17 are arranged which provide mechanical strength to the glass layers 2, 3, 4. In the feed channel 6 two filter zones 18 and two particle traps 19 are arranged. The filter zone 18 is composed out of pillars 20, which are packed preferably with the highest possible density concerning minimum required bonding surface between glass layers 2 and 3 and maximum process capabilities. Due to the closer packing of the pillars 20 a large surface is available for water molecules to deposite on. The particle traps 19 ensure that migrating ice particles will be prevented to block the restriction 8.

## Claims

1. Micro-cooling device comprising:
- an elongate body having a first end and an opposite second end;
- an evaporation chamber arranged at the first end of the elongate body;
- a feed channel arranged between a feed opening, for feeding a high pressure cooling medium, at the second end of the elongate body and the evaporation chamber;
- a discharge channel arranged between the evaporation chamber and a discharge opening at the second end of the elongate body;
- a restriction arranged in the feed channel and adjacent to the evaporation chamber, **characterized in that**
the evaporation chamber comprises a chamber section extending beyond the restriction and being in heat exchanging contact with a first zone of the feed channel upstream of the restriction.

2. Micro-cooling device according to claim 1, comprising an attachment zone in heat exchanging contact with the evaporation chamber, for attaching an electronic component.

3. Micro-cooling device according to claim 2, wherein a high thermal conductive layer (e.g. silicon) is arranged to the attachment zone.

4. Micro-cooling device according to any of the preceding claims, wherein filter means are arranged in the first zone of the feed channel.

5. Micro-cooling device according to claim 4, wherein the filter means comprise a plurality of pillars projecting in the feed channel.

6. Micro-cooling device according to any of the preceding claims, wherein at least one particle trap is arranged in the first zone of the feed channel.

7. Micro-cooling device according to claim 6, wherein the particle trap comprises a plurality of passage openings having dimensions of the same magnitude as the restriction.

8. Micro-cooling device according to any of the preceding claims, comprising:
- a temperature sensor arranged in heat exchanging contact with the feed channel and upstream from the first zone;
- a heater arranged in heat exchanging contact with the evaporation chamber;
- control means for controlling the heater dependent on the temperature sensor measurements.

9. Micro-cooling device according to any of the preceding claims, wherein the feed channel and discharge channel are in counter-flow heat exchanging contact.

10. Micro-cooling device according to any of the preceding claims, wherein the device is composed out of micromachined glass layers.

11. Micro-cooling device according to any of the preceding claims, comprising a compressor with a low pressure inlet connected to the discharge opening and a high pressure outlet connected to the feed opening.
